# EUROPEAN PATENT APPLICATION

(11) **EP 3 675 199 A1**
(43) Date of publication of application: **01.07.2020**
(21) Application number: 17922223.7
(22) Date of filing: 04.12.2017
(51) Int. Cl.: H01L 51/56, H01L 51/52, H01L 27/32

(54) **OLED DISPLAY PANEL AND PREPARATION METHOD THEREOF**

(30) Priority: 25.08.2017 CN 201710745221
(71) Applicant: Shenzhen China Star Optoelectronics Semiconductor Display Technology Co., Ltd., Shenzhen, Guangdong 518132 (CN)
(72) Inventor: TANG, Jia, Shenzhen Guangdong 518132 (CN); IM, Jangsoon, Shenzhen Guangdong 518132 (CN)
(74) Representative: Herrero & Asociados, S.L.
(86) International application number: PCT/CN2017/114459
(87) International publication number: WO 2019/037324

(57) **Abstract**

An OLED display panel is provided with a light blocking layer (300) above a pixel spacing region between an OLED backplate (100) and an encapsulation cover plate (200) so as to block lateral light leakage of pixels, such that the light emitted by each top-emitting OLED (120) is limited to being emitted within a corresponding pixel thereof, thereby effectively avoiding the problems of lateral light leakage and light mixing of the pixels. The preparation method of the display panel includes providing a light blocking layer (300) above a pixel spacing region between an OLED backplate (100) and an encapsulation cover plate (200) so as to block lateral light leakage of pixels, such that the light emitted by each top-emitting OLED (120) is limited to being emitted within a corresponding pixel thereof, thereby effectively avoiding the problems of lateral light leakage and light mixing of the pixels.

## Description

### FIELD OF INVENTION

The present disclosure relates to the field of display technologies, and more particularly to an organic light emitting diode (OLED) display panel and a method of manufacturing the same.

### BACKGROUND OF INVENTION

Organic light emitting diode (OLED) displays have many advantages such as self-emission, low driving voltage, high luminous efficiency, short response time, high definition and contrast, wide viewing angles, wide operating temperature range, flexible display and large-area full color display. It is recognized as the most promising display device in the industry. At present, OLED products are mainly distributed in small-sized mobile phones, pads, and larger-sized television (TV) screens.

OLED has an anode, an organic light emitting material layer, and a cathode formed on a substrate in this order. In an application direction of large-size OLED displays, most of products on a market use a bottom emission structure. The cathode of the OLED uses a thicker metal layer. With the OLED display panel with this structure, light emitted from the organic light emitting material layer needs to penetrate a planarization layer (PLN) layer and a thin film transistor (TFT) layer below it. This reduces luminous efficiency. Therefore, as a resolution increases, bottom emission OLEDs are limited by an aperture ratio, making it difficult to achieve high resolution. More and more practitioners are turning their attention to a development of top emission OLEDs to improve luminous efficiency and achieve high-resolution displays.

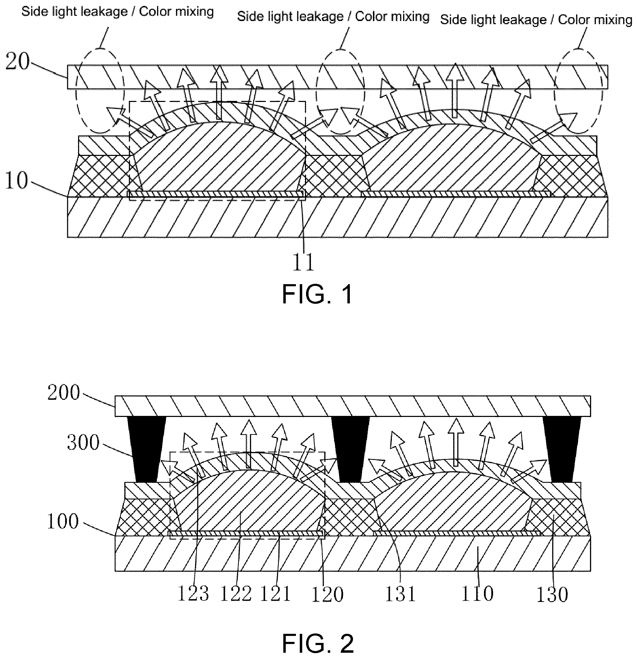

But for a full-color top-emitting OLED display panel, as shown in FIG. 1, because an OLED 11 of each pixel is not only directed perpendicularly to a cover plate 20, it emits light above an OLED back plate 10 in a similar manner to radiation. In addition, because the cover plate 20 and the OLED back plate 10 are not provided with a block between each pixel. Then this easily leads to issue that the light emitted by the OLED 11 of the pixel is incident on an area of another pixel, causing the pixel to leak light laterally, and then issue of color mixing between the pixels, that is, a circle mark in the figure.

### SUMMARY OF INVENTION

An object of the present invention is to provide an organic light emitting diode (OLED) display panel, in which a light shielding layer is provided between an OLED back plate and a package cover plate above a pixel spaced area, thereby limiting light emitted by each of the top emission OLEDs to be emitted in a corresponding pixel, thereby effectively avoiding issue of lateral light leakage and color mixing of pixels.

An object of the present invention is to provide a method of manufacturing an OLED display panel, a light shielding layer is provided between an OLED back plate and a package cover plate above a pixel spaced area, thereby limiting light emitted by each of the top emission OLEDs to be emitted in a corresponding pixel, thereby effectively avoiding issue of lateral light leakage and color mixing of pixels.

To achieve the above object, an embodiment of the present invention provides an organic light emitting diode (OLED) display panel, comprising an OLED back plate and a package cover plate disposed opposite to each other, and a light shielding layer disposed on a side of the package cover plate close to the OLED back plate; the OLED back plate comprises a thin film transistor (TFT) array substrate and a plurality of top emission OLEDs arranged in an array on the TFT array substrate; the OLED back plate has a pixel spaced area and a plurality of pixel light emitting areas spaced out from the pixel spaced area and corresponding to the plurality of top emission OLEDs one-to-one; and the light shielding layer is disposed between the OLED back plate and the package cover plate and correspondingly abuts on the pixel spaced area of the OLED back plate.

In an embodiment of the present invention, the light shielding layer comprises an organic photoresist material or an inorganic material.

In an embodiment of the present invention, each of the top emission OLEDs comprises an anode, an organic light emitting material layer, and a transparent cathode stacked on the TFT array substrate in order from bottom to top.

In an embodiment of the present invention, the OLED back plate further comprises a pixel definition layer disposed on the TFT array substrate and the anode, the pixel definition layer has via holes exposing part of the anode, the organic light emitting material layer of each of the top emission OLEDs is correspondingly disposed in one of the via holes; an area of the OLED back plate corresponding to the pixel definition layer is the pixel spaced area, and an area of the OLED back plate corresponding to the via hole is the pixel light emitting area; the light shielding layer is correspondingly disposed above the pixel definition layer.

In an embodiment of the present invention, a material of the organic light emitting material layer comprises an organic evaporation material or an inkjet printing material.

An embodiment of the present invention further provides a method of manufacturing an OLED display panel, comprising following steps: step S1, providing a TFT array substrate, and forming a plurality of top emission OLEDs arranged in an array on the TFT array substrate to obtain an OLED back plate; wherein the OLED back plate has a pixel spaced area and a plurality of pixel light emitting areas spaced out from the pixel spaced area and corresponding to the plurality of top emission OLEDs one-to-one; step S2, providing a package cover plate, and forming a light shielding layer on the package cover plate corresponding to the pixel spaced area of the OLED back plate; step S3: orienting the light shielding layer formed on the package cover plate toward the OLED back plate, and assembling and packaging the package cover plate and the OLED back plate, such that the light shielding layer abuts on the pixel spaced area of the OLED back plate.

In an embodiment of the present invention, in the step S2, the light shielding layer comprises an organic photoresist material, and the light shielding layer is made by a yellow light process; or the light shielding layer comprises an inorganic material, and the light shielding layer is obtained through a film forming process, a yellow light process, and an etching process in sequence; the yellow light process comprises a photoresist coating step, an exposure step, and a development step which are sequentially performed; the film forming process uses a chemical vapor deposition process or a physical vapor deposition process; the etching process uses a dry etching process or a wet etching process.

In an embodiment of the present invention, in the step S1, each of the top emission OLEDs comprises an anode, an organic light emitting material layer, and a transparent cathode stacked on the TFT array substrate in order from bottom to top.

In an embodiment of the present invention, in the step S1, the method further comprises forming a pixel definition layer on the TFT array substrate and the anode, the pixel definition layer has via holes exposing part of the anode, the organic light emitting material layer of each of the top emission OLEDs is correspondingly disposed in one of the via holes; an area of the OLED back plate corresponding to the pixel definition layer is the pixel spaced area, and an area of the OLED back plate corresponding to the via hole is the pixel light emitting area; in the step S3, the light shielding layer is correspondingly disposed above the pixel definition layer.

In an embodiment of the present invention, in the step S1, a material of the organic light emitting material layer comprises an organic evaporation material, and the organic light emitting material layer is formed by an evaporation process; or the material of the organic light emitting material layer comprises an inkjet printing material, and the organic light emitting material layer is formed by an inkjet printing process.

An embodiment of the present invention further provides an organic light emitting diode (OLED) display panel, comprising an OLED back plate and a package cover plate disposed opposite to each other, and a light shielding layer disposed on a side of the package cover plate close to the OLED back plate; the OLED back plate comprises a thin film transistor (TFT) array substrate and a plurality of top emission OLEDs arranged in an array on the TFT array substrate; the OLED back plate has a pixel spaced area and a plurality of pixel light emitting areas spaced out from the pixel spaced area and corresponding to the plurality of top emission OLEDs one to one; and the light shielding layer is disposed between the OLED back plate and the package cover plate and correspondingly abuts on the pixel spaced area of the OLED back plate; the light shielding layer comprises an organic photoresist material or an inorganic material; each of the top emission OLEDs comprises an anode, an organic light emitting material layer, and a transparent cathode stacked on the TFT array substrate in order from bottom to top.

Beneficial effects of the present invention are that: an OLED display panel of an embodiment of the present invention is provided with a light shielding layer between an OLED back plate and a package cover plate above a pixel spaced area to block lateral light leakage of pixels, thereby limiting light emitted by each of the top emission OLEDs to be emitted in a corresponding pixel, thereby effectively avoiding issue of lateral light leakage and color mixing of the pixels. In a method of manufacturing an OLED display panel of an embodiment of the present invention, a light shielding layer is provided between an OLED back plate and a package cover plate above the pixel spaced area to block lateral light leakage of pixels, thereby limiting light emitted by each of the top emission OLEDs to be emitted in a corresponding pixel, thereby effectively avoiding issue of lateral light leakage and color mixing of the pixels.

In order to further understand features and technical contents of the present invention, please refer to the following detailed description and accompanying drawings of the present invention. However, drawings are only provided for reference and description, and are not intended to limit the present invention.

### DESCRIPTION OF DRAWINGS

The following detailed description of the specific embodiments of the present invention will make the technical solution and other beneficial effects of the present invention obvious with reference to the drawings.

In the drawings,
FIG. 1 is a schematic diagram of pixel side light leakage and color mixing in a conventional organic light emitting diode (OLED) display panel.
FIG. 2 is a schematic structural diagram of an OLED display panel according to an embodiment of the present invention.
FIG. 3 is a flowchart of a method of manufacturing an OLED display panel according to an embodiment of the present invention.
FIG. 4 is a schematic diagram of step S1 of a method of manufacturing an OLED display panel according to an embodiment of the present invention.
FIG. 5 is a schematic diagram of step S2 of a method of manufacturing an OLED display panel according to an embodiment of the present invention.

### DETAILED DESCRIPTION OF PREFERRED EMBODIMENTS

In order to further explain the technical means adopted by the present invention and its effects, the following describes in detail with reference to the preferred embodiments of the present invention and the accompanying drawings.

Referring to FIG. 2, an embodiment of the present invention first provides an organic light emitting diode (OLED) display panel comprising an OLED back plate 100 and a package cover plate 200 disposed opposite to each other, and a light shielding layer 300 disposed on a side of the package cover plate 200 close to the OLED back plate 100 and between the OLED back plate 100 and the package cover plate 200.

The OLED back plate 100 comprises a thin film transistor (TFT) array substrate 110 and a plurality of top emission OLEDs 120 arranged in an array on the TFT array substrate 110.

The OLED back plate 100 has a pixel spaced area and a plurality of pixel light emitting areas spaced out from the pixel spaced area and corresponding to the plurality of top emission OLEDs 120 one-to-one.

The light shielding layer 300 is correspondingly abuts on the pixel spaced area of the OLED back plate 100, thereby limiting light emitted by each of the top emission OLEDs 120 to be emitted in a corresponding pixel to block lateral light leakage of pixels.

In details, the light shielding layer 300 may be an organic photoresist material. For example, polyimide (PI), black matrix (BM) material, or other organic photoresistive material with low light transmittance is specifically formed by a yellow light process. The yellow light process specifically includes a photoresist coating step, an exposure step, and a development step that are sequentially performed. Or,

The light shielding layer 300 may also be made of an inorganic material with a low light transmittance, and is specifically formed by a film formation process, a yellow light process, and an etching process performed in this order. The film forming process uses a chemical vapor deposition (CVD) process or a physical vapor deposition (PVD) process. The yellow light process includes a photoresist coating step, an exposure step, and a development step which are sequentially performed. The etching process uses a dry etching process or a wet etching process.

Specifically, the TFT array substrate 110 is provided with a plurality of TFTs (not shown) arranged to drive the top emission OLED 120. The type of the TFT is not limited, and it may be any type of TFT, such as a low temperature poly-silicon (LTPS) TFT, an oxide TFT, or a solid-phase crystallization (SPC) TFT.

In details, each of the top emission OLEDs 120 comprises an anode 121, an organic light emitting material layer 122, and a transparent cathode 123 stacked on the TFT array substrate 110 in order from bottom to top.

In details, the OLED back plate 100 further comprises a pixel definition layer (PDL) 130 disposed on the TFT array substrate 110 and the anode 121, the pixel definition layer 130 has via holes 131 exposing part of the anode 121, the organic light emitting material layer 122 of each of the top emission OLEDs 120 is correspondingly disposed in one of the via holes 131.

In details, an area of the OLED back plate 100 corresponding to the pixel definition layer 130 is the pixel spaced area, and an area of the OLED back plate 100 corresponding to the via hole 131 is the pixel light emitting area.

In details, the light shielding layer 300 is correspondingly disposed above the pixel definition layer 130.

Specifically, the organic light emitting material layer 122 may be an organic evaporation material, which is formed by an evaporation process, and the pixel definition layer 130 may be a conventional non-hydrophobic PDL material; or, The organic light emitting material layer 122 may also be made of inkjet printing (IJP). The organic light emitting material layer 122 is formed by an ink jet printing process. The pixel definition layer 130 needs to use hydrophobic PDL material.

The OLED display panel of an embodiment of the present invention is provided with a light shielding layer 300 between an OLED back plate 100 and a package cover plate 200 above a pixel spaced area to block lateral light leakage of pixels, thereby limiting light emitted by each of the top emission OLEDs 120 to be emitted in a corresponding pixel, thereby effectively avoiding issue of lateral light leakage and color mixing of the pixels.

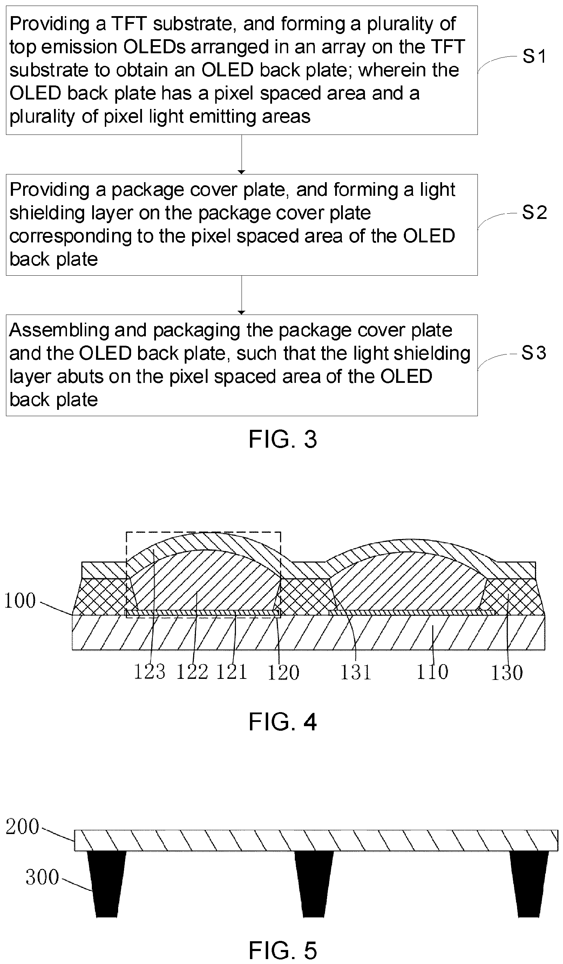

Referring to FIG. 3, based on the OLED display panel described above, an embodiment of the present invention also provides a method of manufacturing an OLED display panel, comprising following steps:
Step S1, referring to FIG. 4 providing a TFT array substrate 110, and forming a plurality of top emission OLEDs 120 arranged in an array on the TFT array substrate 110 to obtain an OLED back plate 100; wherein the OLED back plate 100 has a pixel spaced area and a plurality of pixel light emitting areas spaced out from the pixel spaced area and corresponding to the plurality of top emission OLEDs 120 one-to-one.

Specifically, the TFT array substrate 110 is provided with a plurality of TFTs arranged to drive the top emission OLED 120. The type of the TFT is not limited, and it may be any type of TFT, such as a low temperature poly-silicon (LTPS) TFT, an oxide TFT, or a solid-phase crystallization (SPC) TFT.

In details, each of the top emission OLEDs 120 comprises an anode 121, an organic light emitting material layer 122, and a transparent cathode 123 stacked on the TFT array substrate 110 in order from bottom to top.

In details, the step S1 further includes, before forming the organic light emitting material layer 122 of the plurality of top emission OLEDs 120, forming a pixel definition layer 130 on the TFT array substrate 110 and the anode 121, the pixel definition layer 130 has via holes 131 exposing part of the anode 121, the organic light emitting material layer 122 of each of the top emission OLEDs 120 is correspondingly disposed in one of the via holes 131; an area of the OLED back plate 100 corresponding to the pixel definition layer 130 is the pixel spaced area, and an area of the OLED back plate 100 corresponding to the via hole 131 is the pixel light emitting area.

Specifically, the organic light emitting material layer 122 may be an organic evaporation material, which is formed by an evaporation process, and the pixel definition layer 130 may be a conventional non-hydrophobic PDL material; or, The organic light emitting material layer 122 may also be made of inkjet printing. The organic light emitting material layer 122 is formed by an ink jet printing process. The pixel definition layer 130 needs to use hydrophobic PDL material.

Step S2, referring to FIG. 5, providing a package cover plate 200, and forming a light shielding layer 300 on the package cover plate 200 corresponding to the pixel spaced area of the OLED back plate 100.

In details, the light shielding layer 300 may be an organic photoresist material. For example, polyimide (PI), black matrix (BM) material, or other organic photoresistive material with low light transmittance. In the step S3, the light shielding layer 300 is specifically formed by a yellow light process. The yellow light process specifically includes a photoresist coating step, an exposure step, and a development step that are sequentially performed. Or,

The light shielding layer 300 may also be made of an inorganic material with a low light transmittance, and is specifically formed by a film formation process, a yellow light process, and an etching process performed in this order in the step 3. The film forming process uses a chemical vapor deposition (CVD) process or a physical vapor deposition (PVD) process. The yellow light process includes a photoresist coating step, an exposure step, and a development step which are sequentially performed. The etching process uses a dry etching process or a wet etching process.

Step S3: orienting the light shielding layer 300 formed on the package cover plate 200 toward the OLED back plate 100, and assembling and packaging the package cover plate 200 and the OLED back plate 100, such that the light shielding layer 300 abuts on the pixel spaced area of the OLED back plate 10 to obtain the OLED display panel shown in FIG. 2, thereby limiting light emitted by each of the top emission OLEDs 120 to be emitted in a corresponding pixel to block lateral light leakage of pixels.

Specifically, in the step S3, after the package cover plate 200 and the OLED back plate 100 are packaged, the light shielding layer 300 is correspondingly disposed above the pixel definition layer 130.

In the method of manufacturing the OLED display panel of an embodiment of the present invention, a light shielding layer 300 is provided between an OLED back plate 100 and a package cover plate 200 above the pixel spaced area to block lateral light leakage of pixels, thereby limiting light emitted by each of the top emission OLEDs 120 to be emitted in a corresponding pixel, thereby effectively avoiding issue of lateral light leakage and color mixing of the pixels. In summary, the OLED display panel of an embodiment of the present invention is provided with a light shielding layer between an OLED back plate and a package cover plate above a pixel spaced area to block lateral light leakage of pixels, thereby limiting light emitted by each of the top emission OLEDs to be emitted in a corresponding pixel, thereby effectively avoiding issue of lateral light leakage and color mixing of the pixels. In the method of manufacturing the OLED display panel of an embodiment of the present invention, a light shielding layer is provided between an OLED back plate and a package cover plate above the pixel spaced area to block lateral light leakage of pixels, thereby limiting light emitted by each of the top emission OLEDs to be emitted in a corresponding pixel, thereby effectively avoiding issue of lateral light leakage and color mixing of the pixels.

As described above, for a person of ordinary skill in the art, various other corresponding changes and modifications can be made according to the technical solutions and technical concepts of the present invention. All these changes and modifications should belong to the protection scope of the claims of the present invention.

## Claims

1. An organic light emitting diode (OLED) display panel, comprising:
an OLED back plate and a package cover plate disposed opposite to each other, and a light shielding layer disposed on a side of the package cover plate close to the OLED back plate;
wherein the OLED back plate comprises a thin film transistor (TFT) array substrate and a plurality of top emission OLEDs arranged in an array on the TFT array substrate;
wherein the OLED back plate has a pixel spaced area and a plurality of pixel light emitting areas spaced out from the pixel spaced area and corresponding to the plurality of top emission OLEDs one-to-one; and
wherein the light shielding layer is disposed between the OLED back plate and the package cover plate and correspondingly abuts on the pixel spaced area of the OLED back plate.

2. The OLED display panel according to Claim 1, wherein the light shielding layer comprises an organic photoresist material or an inorganic material.

3. The OLED display panel according to Claim 1, wherein each of the top emission OLEDs comprises an anode, an organic light emitting material layer, and a transparent cathode stacked on the TFT array substrate in order from bottom to top.

4. The OLED display panel according to Claim 3, wherein the OLED back plate further comprises a pixel definition layer disposed on the TFT array substrate and the anode, the pixel definition layer has via holes exposing part of the anode, the organic light emitting material layer of each of the top emission OLEDs is correspondingly disposed in one of the via holes;
an area of the OLED back plate corresponding to the pixel definition layer is the pixel spaced area, and an area of the OLED back plate corresponding to the via hole is the pixel light emitting area;
the light shielding layer is correspondingly disposed above the pixel definition layer.

5. The OLED display panel according to Claim 3, wherein a material of the organic light emitting material layer comprises an organic evaporation material or an inkjet printing material.

6. A method of manufacturing an OLED display panel, comprising following steps:
step S1, providing a TFT array substrate, and forming a plurality of top emission OLEDs arranged in an array on the TFT array substrate to obtain an OLED back plate; wherein the OLED back plate has a pixel spaced area and a plurality of pixel light emitting areas spaced out from the pixel spaced area and corresponding to the plurality of top emission OLEDs one-to-one;
step S2, providing a package cover plate, and forming a light shielding layer on the package cover plate corresponding to the pixel spaced area of the OLED back plate;
step S3: orienting the light shielding layer formed on the package cover plate toward the OLED back plate, and assembling and packaging the package cover plate and the OLED back plate, such that the light shielding layer abuts on the pixel spaced area of the OLED back plate.

7. The method of manufacturing the OLED display panel according to Claim 6, wherein in the step S2, the light shielding layer comprises an organic photoresist material, and the light shielding layer is made by a yellow light process; or,
the light shielding layer comprises an inorganic material, and the light shielding layer is obtained through a film forming process, a yellow light process, and an etching process in sequence;
wherein the yellow light process comprises a photoresist coating step, an exposure step, and a development step which are sequentially performed;
wherein the film forming process uses a chemical vapor deposition process or a physical vapor deposition process;
wherein the etching process uses a dry etching process or a wet etching process.

8. The method of manufacturing the OLED display panel according to Claim 6, wherein in the step S1, each of the top emission OLEDs comprises an anode, an organic light emitting material layer, and a transparent cathode stacked on the TFT array substrate in order from bottom to top.

9. The method of manufacturing the OLED display panel according to Claim 8, wherein in the step S1, the method further comprises forming a pixel definition layer on the TFT array substrate and the anode, the pixel definition layer has via holes exposing part of the anode, the organic light emitting material layer of each of the top emission OLEDs is correspondingly disposed in one of the via holes;
an area of the OLED back plate corresponding to the pixel definition layer is the pixel spaced area, and an area of the OLED back plate corresponding to the via hole is the pixel light emitting area;
in the step S3, the light shielding layer is correspondingly disposed above the pixel definition layer.

10. The method of manufacturing the OLED display panel according to Claim 8, wherein in the step S1, a material of the organic light emitting material layer comprises an organic evaporation material, and the organic light emitting material layer is formed by an evaporation process; or,
the material of the organic light emitting material layer comprises an inkjet printing material, and the organic light emitting material layer is formed by an inkjet printing process.

11. An organic light emitting diode (OLED) display panel, comprising:
an OLED back plate and a package cover plate disposed opposite to each other, and a light shielding layer disposed on a side of the package cover plate close to the OLED back plate;
wherein the OLED back plate comprises a thin film transistor (TFT) array substrate and a plurality of top emission OLEDs arranged in an array on the TFT array substrate;
wherein the OLED back plate has a pixel spaced area and a plurality of pixel light emitting areas spaced out from the pixel spaced area and corresponding to the plurality of top emission OLEDs one to one; and
wherein the light shielding layer is disposed between the OLED back plate and the package cover plate and correspondingly abuts on the pixel spaced area of the OLED back plate;
wherein the light shielding layer comprises an organic photoresist material or an inorganic material;
wherein each of the top emission OLEDs comprises an anode, an organic light emitting material layer, and a transparent cathode stacked on the TFT array substrate in order from bottom to top.
